# EUROPEAN PATENT APPLICATION

(11) **EP 2 325 895 A1**
(43) Date of publication of application: **25.05.2011**
(21) Application number: 09811543.9
(22) Date of filing: 03.09.2009
(51) Int. Cl.: H01L 31/042

(54) **CONCENTRATED SOLAR POWER GENERATING MODULE AND METHOD FOR MANUFACTURING CONCENTRATED SOLAR POWER GENERATING MODULE**

(30) Priority: 08.09.2008 JP 2008230261; 08.09.2008 JP 2008230262
(71) Applicant: Sharp Kabushiki Kaisha, Osaka-shi, Osaka 545-8522 (JP)
(72) Inventor: FUTAWARI, Motonari, Osaka 545-8522 (JP)
(74) Representative: Müller - Hoffmann & Partner
(86) International application number: PCT/JP2009/065415
(87) International publication number: WO 2010/027018

(57) **Abstract**

A concentrator photovoltaic module (1) according to an embodiment includes a concentrating lens (50) configured to concentrate sunlight (Ls), a photovoltaic cell element (11) configured to convert the concentrated sunlight (Ls) into electricity, a receiver baseboard (20) on which the photovoltaic cell element (11) is mounted, a heat sink (60) configured to dissipate heat coming from the receiver baseboard (20), a module plate (70) to which the heat sink (60) is attached, and an opening (70w) that is formed in the module plate (70) and in which the photovoltaic cell element (11) and the receiver baseboard (20) are provided. The receiver baseboard (20) is fastened to the heat sink (60), and the heat sink (60) is fastened to the module plate (70) around the opening (70w).

## Description

### Technical Field

The present invention relates to concentrator photovoltaic modules, and methods for manufacturing the concentrator photovoltaic modules.

### Background Art

Photovoltaic devices generally have a non-concentrator and fixed flat-plate structure in which a photovoltaic module including photovoltaic cell elements that are arranged with no space between them is installed on a roof or the like. Techniques for reducing the number of photovoltaic cell elements included in the photovoltaic device have been proposed because the photovoltaic cell element costs higher than other members (parts) of the device.

Specifically, there is a proposed technique of concentrating sunlight using an optical lens, a reflecting mirror, or the like, and irradiating a small area of photovoltaic cell elements with the concentrated sunlight, to increase generated power per unit area of the photovoltaic cell elements, thereby reducing the cost of the photovoltaic cell elements (i.e., the cost of the photovoltaic device).

In general, as the concentration ratio increases, the photoelectric conversion efficiency of a photovoltaic cell element increases. If, however, the position of the photovoltaic cell element is fixed, sunlight enters at an oblique angle in most time and cannot be efficiently utilized. Therefore, a tracking concentrator photovoltaic device has been proposed that tracks the sun so that the front surface of the device is invariably normal to sunlight, thereby achieving a high concentration ratio (see, for example, Patent Documents 1-5).

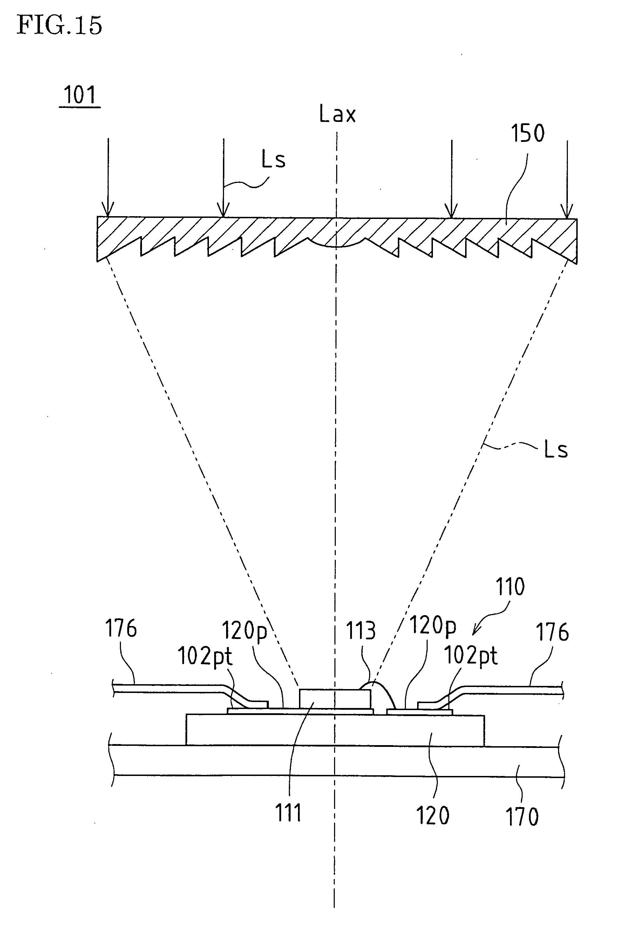

FIG. 15 is a diagram for describing an exemplary structure of a concentrator photovoltaic module used in a conventional tracking concentrator photovoltaic device.

The conventional concentrator photovoltaic module 101 includes a concentrating lens 150 that receives and concentrates sunlight Ls that enters in parallel to an optical axis Lax and perperndicularly for a plane of incidence, and a photovoltaic cell 110 that converts the sunlight Ls concentrated by the concentrating lens 150 into electricity. Also, the photovoltaic cell 110 includes a photovoltaic cell element 111 that converts the concentrated sunlight Ls into electricity. The photovoltaic cell 110 (the photovoltaic cell element 111) is mounted on a receiver baseboard 120.

The receiver baseboard 120 is coupled to a module plate 170 that is a part of a housing of the concentrator photovoltaic module 101. The module plate 170 is used to position the receiver baseboard 120 and dissipate heat coming from the receiver baseboard 120.

A pair of interconnect patterns 120p is formed on the receiver baseboard 120. The photovoltaic cell element 111 is attached to one of the interconnect patterns 120p by die bonding, while the photovoltaic cell element 111 is connected via a wire 113 to the other interconnect pattern 120p by wire bonding. Also, an external lead 176 is connected to an end portion of each interconnect pattern that serves as a connection terminal 120pt for external connection.

Patent Document 1: JP 2002-289896A
Patent Document 2: JP 2002-289897A
Patent Document 3: JP 2002-289898A
Patent Document 4: JP 2006-278581A
Patent Document 5: JP 2007-201109A

### Disclosure of Invention

### Problem to be Solved by the Invention

The conventional tracking concentrator photovoltaic device employs the concentrator photovoltaic module 101 that achieves a high concentration ratio using the concentrating lens 150.

Because the concentrator photovoltaic module 101 has a high concentration ratio, high thermal energy is applied to the photovoltaic cell 110. Specifically, the photovoltaic cell element 111, the receiver baseboard 120, the connection terminal 120pt are kept at high temperature. Also, the photovoltaic cell 110 needs to be accurately positioned in order to prevent an unnecessary position from being irradiated with the concentrated sunlight Ls.

Therefore, it is important that the photovoltaic cell 110 should be accurately positioned with respect to the module plate 170 (the concentrating lens 150), a heat sink should be effectively provided in order to efficiently dissipate heat coming from the photovoltaic cell 110, and the connection accuracy (i.e., a connection strength or a connection position) of the external lead 176 to the connection terminal 120pt should be improved, or the insulating property and the weatherability (i.e., water resistance, contamination resistance, and the like) should be improved, thereby ensuring the reliability

The present invention has been made in view of the aforementioned circumstances. It is an object of the present invention to provide a concentrator photovoltaic module in which a photovoltaic cell element (photovoltaic cell) is accurately positioned and firmly fixed to a module plate to improve the insulating property and the weatherability, thereby improving the mechanical strength, the heat dissipation performance, and the reliability. It is also an object of the present invention to provide a method for manufacturing the concentrator photovoltaic module with high workability

### Means for Solving Problem

A concentrator photovoltaic module according to the present invention includes a concentrating lens configured to concentrate sunlight, a photovoltaic cell element configured to convert the sunlight concentrated by the concentrating lens into electricity, a receiver baseboard on which the photovoltaic cell element is mounted, a heat sink configured to dissipate heat coming from the receiver baseboard, a module plate to which the heat sink is attached, and an opening that is formed in the module plate and in which the photovoltaic cell element and the receiver baseboard are provided. The receiver baseboard is fastened to the heat sink, and the heat sink is fastened to the module plate around the opening.

With this structure, the receiver baseboard and the heat sink can be accurately positioned and firmly fixed to the module plate, thereby providing the concentrator photovoltaic module in which the photovoltaic cell element (photovoltaic cell) can be accurately positioned and firmly fixed to the module plate, and therefore, the mechanical strength, the heat dissipation performance, and the reliability can be improved.

Also, in the concentrator photovoltaic module of the present invention may include a connection terminal that is formed on the receiver baseboard and through which generated power is extracted from the photovoltaic cell element, and a connector having and a connector terminal connected to the connection terminal. The connector may be fastened to the heat sink.

With this structure, the connector can be accurately positioned and firmly fixed to the heat sink, and the connector terminal can be accurately and firmly connected to the connection terminal, thereby improving the connection strength of the connector, resulting in an improvement in connection reliability.

Also, the concentrator photovoltaic module of the present invention, the heat sink may be larger than the receiver baseboard and be of a size to cover the opening.

With this structure, the photovoltaic cell element (photovoltaic cell) can be accommodated farther inside the concentrator photovoltaic module 1 than the module plate (heat sink), and the heat sink can be provided outside the module plate, whereby the reliability of the photovoltaic cell element (photovoltaic cell) can be ensured, and the heat dissipation performance can be improved.

Also, in the concentrator photovoltaic module of the present invention, the heat sink may be fastened to the module plate by a pair of plate fastening members provided at rotationally symmetric positions diagonally aligned with respect to a crossing line intersecting opposite sides of the opening at middles of the sides at right angles.

With this structure, the heat sink can be accurately positioned with respect to the module plate.

Also, in the concentrator photovoltaic module of the present invention, the plate fastening member may be a rivet.

With this structure, the heat sink and the module plate can be easily and accurately fastened together to be firmly fixed to each other, resulting in an improvement in mechanical strength and reliability.

Also, in the concentrator photovoltaic module of the present invention, the connector may be fastened to the heat sink by the connector fastening member.

With this structure, the connector and the heat sink can be easily and accurately fastened together to be firmly fixed to each other, resulting in an improvement in mechanical strength and reliability.

Also, in the concentrator photovoltaic module of the present invention, the receiver baseboard may be in the shape of a rectangle and have a notch in one of the long sides of the rectangle. The opening may be in the shape of a rectangle corresponding to the receiver baseboard and have a protrusion corresponding to the notch in one of the long sides of the rectangle.

With this structure, the arrangement, particularly the orientation, of the receiver baseboard with respect to the module plate can be easily and correctly identified, resulting in an improvement in productivity.

Also, the concentrator photovoltaic module of the present invention may further include a receiver resin sealing portion configured to cover the connection terminal, the connector terminal, and the receiver baseboard.

With this structure, surfaces of the connection terminal, the connector terminal, and the receiver baseboard are covered with the receiver resin sealing portion. As a result, the photovoltaic cell element (photovoltaic cell) can be accurately positioned and firmly fixed to the module plate, whereby a region that electronically functions of the surface of the receiver baseboard can be shut off from an ambient environment (water, moisture, etc.). Therefore, the influence of the ambient environment on the connection terminal, the connector terminal, and the receiver baseboard can be prevented, thereby providing the concentrator photovoltaic module in which the insulating property and weatherability (water resistance and contamination resistance) of the connection terminal, the connector terminal, and the receiver baseboard can be improved, and the mechanical strength, the heat dissipation performance, and the reliability can be improved.

Also, the concentrator photovoltaic module of the present invention may include an inner resin confining member provided around a resin sealing portion configured to encapsulate the photovoltaic cell element, and configured to confine the resin sealing portion, and an outer resin confining member provided at an outer circumference of the receiver baseboard and having a top portion higher than a position of the connector terminal. The receiver resin sealing portion may be formed between the inner resin confining member and the outer resin confining member, and may be lower than a top portion of the inner resin confining member.

With this structure, a region where the receiver resin sealing portion is formed (a region filled with the insulating resin) can be accurately demarcated, and the influence of the receiver resin sealing portion on the optical characteristics of the photovoltaic cell (columnar optical member) can be reliably eliminated. Therefore, high light concentration characteristics and reliability can be imparted to the concentrator photovoltaic module.

Also, in the concentrator photovoltaic module of the present invention, the outer resin confining member may be previously formed in the shape of a frame.

With this structure, it is not necessary to use a jig in order to form the receiver resin sealing portion, whereby the outer resin confining member can be accurately formed, and therefore, the receiver resin sealing portion can be easily and accurately formed.

Also, in the concentrator photovoltaic module of the present invention, the receiver baseboard may be in the shape of a rectangle, and the outer resin confining member may include an opening step engaging portion corresponding to a step between the heat sink and the module plate, and may abut the heat sink and the opening at short sides of the receiver baseboard, and abut the module plate at long sides of the receiver baseboard.

With this structure, the outer resin confining member may be engaged with the opening while abutting the heat sink and the module plate, whereby the insulating resin of the receiver resin sealing portion can be prevented from leaking from the outer resin confining member, and the receiver resin sealing portion can be accurately formed.

Also, in the concentrator photovoltaic module of the present invention, the connector may include a connector housing configured to hold the connector terminal. The outer resin confining member may include a connector engaging portion configured to engage with the connector housing.

With this structure, the outer resin confining member can be engaged with the connector housing, whereby the insulating resin of the receiver resin sealing portion can be prevented from leaking from the outer resin confining member via the connector, and therefore, the receiver resin sealing portion can be accurately formed.

Also, a method according to the present invention is provided for manufacturing a concentrator photovoltaic module including a concentrating lens configured to concentrate sunlight, a photovoltaic cell element configured to convert the sunlight concentrated by the concentrating lens into electricity, a receiver baseboard on which the photovoltaic cell element is mounted, a heat sink configured to dissipate heat coming from the receiver baseboard, a module plate to which the heat sink is attached, an opening that is formed in the module plate and in which the photovoltaic cell element and the receiver baseboard are provided, a connection terminal that is formed on the receiver baseboard and through which generated power is extracted from the photovoltaic cell element, and a connector having a connector terminal connected to the connection terminal. The method includes the steps of fastening the receiver baseboard to the heat sink, placing the photovoltaic cell element and the receiver baseboard in the opening, covering the opening with the heat sink, and fastening the heat sink to the module plate around the opening, and connecting the connector terminal to the connection terminal and fastening the connector to the heat sink.

With this structure, the receiver baseboard and the heat sink can be accurately positioned and firmly fixed to the module plate, and the connector can be accurately positioned and firmly fixed to the heat sink, thereby providing the concentrator photovoltaic module in which the photovoltaic cell element and the connector can be accurately positioned and firmly fixed, and therefore, the mechanical strength, the heat dissipation performance, and the reliability can be improved.

Also, a method according to the present invention may be provided for manufacturing a concentrator photovoltaic module including a concentrating lens configured to concentrate sunlight, a photovoltaic cell element configured to convert the sunlight concentrated by the concentrating lens into electricity, a receiver baseboard on which the photovoltaic cell element is mounted, a heat sink configured to dissipate heat coming from the receiver baseboard, a module plate to which the heat sink is attached, an opening that is formed in the module plate and in which the photovoltaic cell element and the receiver baseboard are provided, a connection terminal that is formed on the receiver baseboard and through which generated power is extracted from the photovoltaic cell element, a connector having a connector terminal connected to the connection terminal, and a receiver resin sealing portion configured to cover the connection terminal, the connector terminal, and the receiver baseboard. The method may include the steps of fastening the receiver baseboard to the heat sink, placing the photovoltaic cell element and the receiver baseboard in the opening, covering the opening with the heat sink, and fastening the heat sink to the module plate around the opening, connecting the connector terminal to the connection terminal and fastening the connector to the heat sink, and forming the receiver resin sealing portion configured to cover the connection terminal, the connector terminal, and the receiver baseboard.

With this structure, the receiver baseboard, the heat sink, the module plate, and the connector can be accurately positioned and firmly fixed together, whereby the influence of an ambient environment on the connection terminal, the connector terminal, and the receiver baseboard can be prevented, thereby providing the concentrator photovoltaic module in which the insulating property and weatherability (water resistance and contamination resistance) of the connection terminal, the connector terminal, and the receiver baseboard can be improved, and the mechanical strength, the heat dissipation performance, and the reliability can be improved.

### Effects of the Invention

According to the concentrator photovoltaic module of the present invention, the photovoltaic cell element (photovoltaic cell) can be accurately positioned and firmly fixed to the module plate, whereby the insulating property and the weatherability are advantageously improved, and the mechanical strength, the heat dissipation performance, and the reliability are advantageously improved.

Also, according to the concentrator photovoltaic module manufacturing method of the present invention, the photovoltaic cell element and the connector can be accurately positioned and firmly fixed, whereby a concentrator photovoltaic module having improved heat dissipation performance and reliability can be manufactured with high workability.

### Brief Description of Drawings

[FIG. 1] FIG. 1 is a see-through side view schematically showing a structure of a concentrator photovoltaic module according to Embodiment 1 of the present invention, taken along a plane including an optical axis.
[FIG. 2] FIG. 2 is a perspective view of an outer appearance of the concentrator photovoltaic module, as viewed obliquely from above, in which a photovoltaic cell element is mounted on a receiver baseboard to assemble a photovoltaic cell.
[FIG. 3] FIG. 3 is a perspective view of a concentrator photovoltaic module according to Embodiment 2 of the present invention in which a photovoltaic cell element has been mounted on a receiver baseboard, for describing a step in a method for manufacturing the concentrator photovoltaic module.
[FIG. 4] FIG. 4 is a perspective view of the concentrator photovoltaic module of Embodiment 2 of the present invention in which a photovoltaic cell has been mounted on the receiver baseboard, for describing a step in the method for manufacturing the concentrator photovoltaic module.
[FIG. 5] FIG. 5 is an exploded perspective view of the concentrator photovoltaic module of Embodiment 2 of the present invention before a heat sink is fastened to the receiver baseboard on which the photovoltaic cell is mounted, for describing a step in the method for manufacturing the concentrator photovoltaic module.
[FIG. 6] FIG. 5 is an exploded perspective view of the concentrator photovoltaic module of Embodiment 2 of the present invention after the heat sink is fastened to the receiver baseboard on which the photovoltaic cell is mounted, for describing a step in the method for manufacturing the concentrator photovoltaic module.
[FIG. 7] FIG. 7 is a plan view of the positional relationship between the photovoltaic cell, the receiver baseboard, openings, the heat sink, and a module plate of the concentrator photovoltaic module of Embodiment 2 of the present invention, for describing a step in the method for manufacturing the concentrator photovoltaic module.
[FIG. 8] FIG. 8 is a perspective view of the concentrator photovoltaic module of Embodiment 2 of the present invention in which the heat sink has been fastened to the module plate, for describing a step in the method for manufacturing the concentrator photovoltaic module.
[FIG. 9] FIG. 9 is a perspective view of the concentrator photovoltaic module of Embodiment 2 of the present invention in which connectors have been fastened to the heat sink by connecting connector terminals to connection terminals.
[FIG. 10] FIG. 10 is a see-through side view schematically showing a structure of a concentrator photovoltaic module according to Embodiment 3 of the present invention, taken along a plane including an optical axis.
[FIG. 11] FIG. 11 is a perspective view of the concentrator photovoltaic module of Embodiment 3 of the present invention after connector terminals are connected to connection terminals, connectors are fastened to a heat sink, and the heat sink is fastened to a module plate and before a receiver resin sealing portion is formed, for describing a step in a method for manufacturing the concentrator photovoltaic module.
[FIG. 12] FIG. 12 is a perspective view of the concentrator photovoltaic module of Embodiment 3 of the present invention in which an outer resin confining member has been engaged with the heat sink and the module plate, for describing a step in the method for manufacturing the concentrator photovoltaic module.
[FIG. 13] FIG. 13 is a perspective view of the concentrator photovoltaic module of Embodiment 3 of the present invention in which a receiver resin sealing portion has been formed, for describing a step in the method for manufacturing the concentrator photovoltaic module.
[FIG. 14] FIG. 14 is a diagram for describing the concept of the relationship in the height direction between the inner resin confining member, the outer resin confining member, and the receiver resin sealing portion in the concentrator photovoltaic module of Embodiment 3 of the present invention.
[FIG. 15] FIG. 15 is a diagram for describing an exemplary structure of a concentrator photovoltaic module used in a conventional tracking concentrator photovoltaic device.

### Description of the Invention

Concentrator photovoltaic modules according to embodiments of the present invention and methods for manufacturing the concentrator photovoltaic modules will be described hereinafter with reference to the accompanying drawings.

### <Embodiment 1>

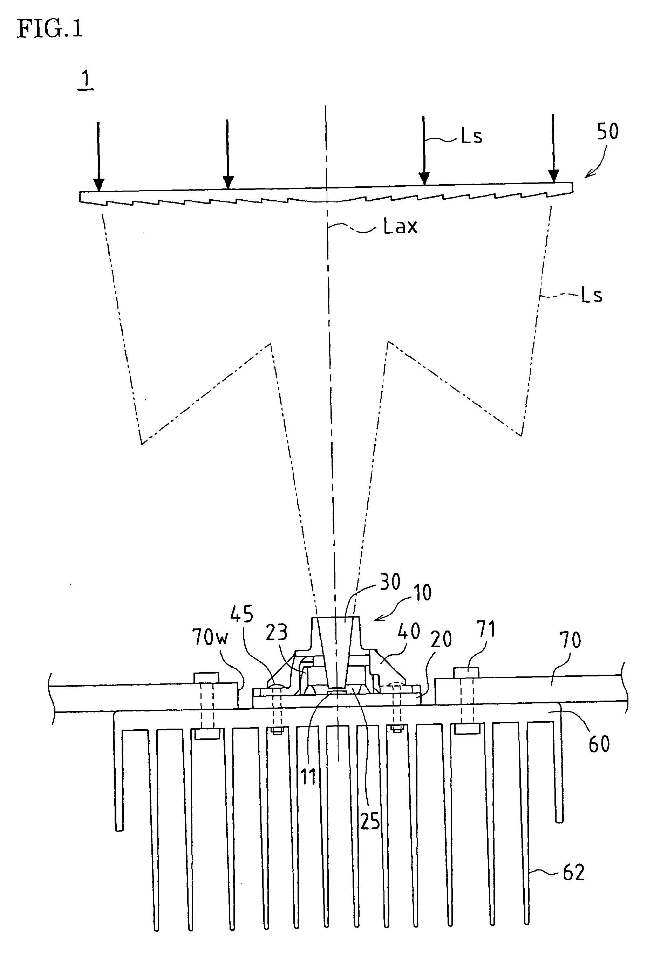

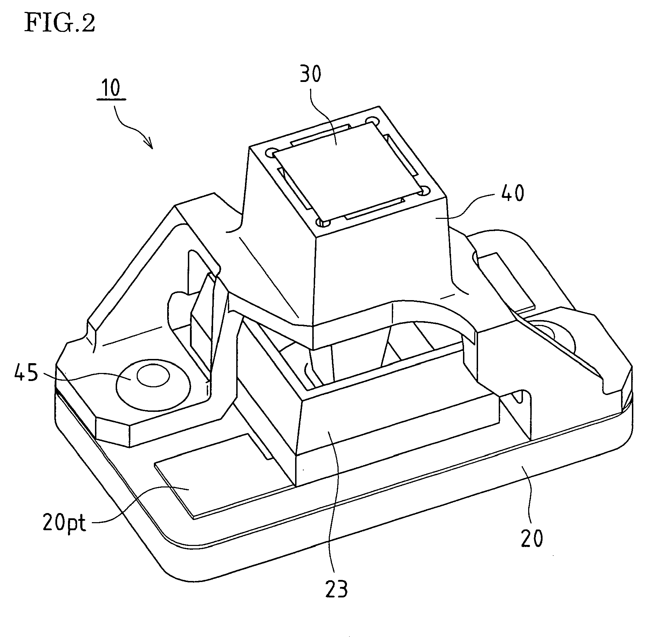

A concentrator photovoltaic module according to Embodiment 1 will be described with reference to FIGS. 1 and 2.

FIG. 1 is a see-through side view schematically showing a structure of the concentrator photovoltaic module of Embodiment 1, taken along a plane including an optical axis. FIG. 2 is a perspective view of an outer appearance of the concentrator photovoltaic module, as viewed obliquely from above, in which a photovoltaic cell element is mounted on a receiver baseboard to assemble a photovoltaic cell.

The concentrator photovoltaic module 1 of this embodiment includes a concentrating lens 50 that concentrates sunlight Ls incident from the direction of an optical axis Lax, a photovoltaic cell element 11 that converts the sunlight Ls concentrated by the concentrating lens 50 into electricity, a receiver baseboard 20 on which the photovoltaic cell element 11 is mounted, a heat sink 60 that dissipates heat coming from the receiver baseboard 20, and a module plate 70 to which the heat sink 60 is attached.

Also, the concentrator photovoltaic module 1 includes an opening 70w that is formed in the module plate 70 and in which the photovoltaic cell element 11 and the receiver baseboard 20 are provided. The receiver baseboard 20 is fastened to the heat sink 60 by fastening members 45. The heat sink 60 is fastened to the module plate 70 around the opening 70w by plate fastening members 71.

Therefore, the receiver baseboard 20 and the heat sink 60 can be accurately positioned and firmly fixed to the module plate 70. As a result, the photovoltaic cell element 11 (photovoltaic cell 10) can be accurately positioned and firmly fixed to the module plate 70, and a higher mechanical strength, heat dissipation performance, and reliability can be imparted to the concentrator photovoltaic module 1.

Note that the photovoltaic cell 10 includes, in addition to the photovoltaic cell element 11, for example, a columnar optical member 30 which brings the concentrated sunlight Ls to the photovoltaic cell element 11, a holder 40 that holds the columnar optical member 30, and a resin sealing portion 25 that protects a surface of the photovoltaic cell element 11 and with which a space between the photovoltaic cell element 11 and the columnar optical member 30 is filled.

Connection terminals 20pt through which generated power is extracted from the photovoltaic cell element 11 are formed on the receiver baseboard 20. Also, the photovoltaic cell element 11 is encapsulated by the resin sealing portion 25 that is held back or confined by an inner resin confining member 23. The resin sealing portion 25 is formed of a translucent resin with which the space between the photovoltaic cell element 11 and the columnar optical member 30 is filled. Examples of the translucent resin include epoxy resins, silicone resins, and the like.

The columnar optical member 30 is arranged to face the photovoltaic cell element 11. The columnar optical member 30, which is held by the holder 40, guides the concentrated sunlight Ls to the photovoltaic cell element 11. The holder 40 is fastened to the receiver baseboard 20 and the heat sink 60 by the fastening members 45 fastening the receiver baseboard 20 and the heat sink 60 together.

Examples of the fastening member 45 include rivets, screws, and the like. Note that, when rivets are used, the parts can be easily and accurately fastened together to be firmly fixed to each other, resulting in an improvement in mechanical strength and reliability

Thermal energy of the concentrated sunlight Ls applied to the columnar optical member 30 is dissipated via the holder 40 and the receiver baseboard 20 to the heat sink 60, whereby heat dissipation characteristics can be improved. Also, the holder 40 can dissipate, via the receiver baseboard 20 and the heat sink 60, thermal energy that is applied to the holder 40 by an unnecessary portion having a long wavelength of the sunlight Ls.

Specifically, the holder 40 abuts the receiver baseboard 20 outside the columnar optical member 30 (at a position away from the photovoltaic cell element 11), and therefore, can dissipate heat while reducing the influence on the photovoltaic cell element 11. Therefore, the heat dissipation performance of the photovoltaic cell 10 (the photovoltaic cell element 11 and the holder 40) can be improved.

The heat sink 60 is larger than the receiver baseboard 20 and is of a size to cover the opening 70w. Also, the heat sink 60 is provided farther outside than the module plate 70 (i.e., exposed to the outside).

Specifically, the photovoltaic cell element 11 (the photovoltaic cell 10) and the receiver baseboard 20 can be accommodated farther inside the concentrator photovoltaic module 1 than the module plate 70 (the heat sink 60) (i.e., can be located in a space between the concentrating lens 50 and the heat sink 60), and the heat sink 60 can be provided outside the module plate 70, whereby the reliability of the photovoltaic cell 10 can be ensured and the heat dissipation performance can be improved. Note that the heat sink 60 has fins 62 protruding outside the module plate 70, whereby the heat dissipation performance can be improved.

The heat sink 60 is preferably fastened to the module plate 70 by the plate fastening members 71. With this structure, the heat sink 60 and the module plate 70 can be easily and accurately fastened together to be firmly fixed to each other, resulting in an improvement in mechanical strength and reliability.

### <Embodiment 2>

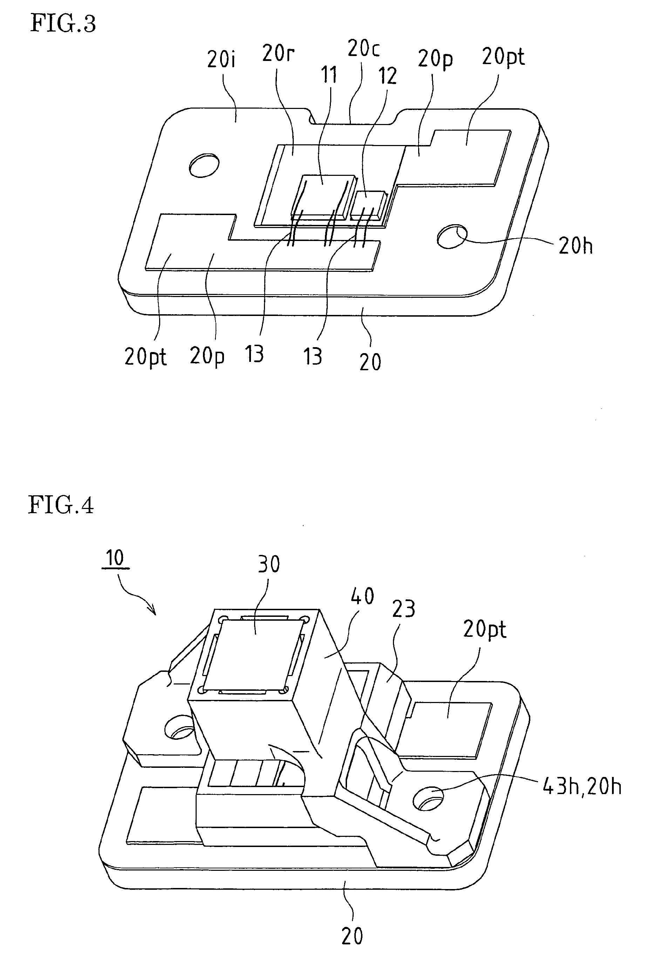

Next, a concentrator photovoltaic module according to Embodiment 2 and a method for manufacturing the concentrator photovoltaic module will be described with reference to FIGS. 3-9.

The concentrator photovoltaic module 1 of this embodiment includes the same components as those of the concentrator photovoltaic module 1 of Embodiment 1. Therefore, details and a manufacturing process of the concentrator photovoltaic module 1 of this embodiment will be mainly described using the same reference characters.

FIG. 3 is a perspective view of the concentrator photovoltaic module of Embodiment 2 in which the photovoltaic cell element has been mounted on the receiver baseboard, for describing a step in the method for manufacturing the concentrator photovoltaic module.

Initially, the photovoltaic cell element 11 is mounted onto the receiver baseboard 20. Specifically, the photovoltaic cell element 11 and an anti-backflow diode 12 are attached by die bonding to an interconnect pattern 20p formed on the receiver baseboard 20, and wires 13 are attached to the photovoltaic cell element 11, the anti-backflow diode 12, and another interconnect pattern 20p by wire bonding (baseboard preparing step). Note that the photovoltaic cell element 11 is made of, for example, a compound semiconductor, and the anti-backflow diode 12 is made of, for example, a silicon single crystal.

The interconnect patterns 20p are provided corresponding to positive and negative electrodes of the photovoltaic cell element 11 and the anti-backflow diode 12. For example, the interconnect pattern 20p to which the photovoltaic cell element 11 and the anti-backflow diode 12 are attached by die bonding is a positive electrode, while the interconnect pattern 20p to which the photovoltaic cell element 11 and the anti-backflow diode 12 are connected by wire bonding is a negative electrode.

The interconnect patterns 20p are formed of a thin metal plate made of copper formed on an insulating film 20i formed on a surface of the receiver baseboard 20. On the interconnect pattern 20p that will serve as a positive electrode, a solder resist 20r is formed around the photovoltaic cell element 11 and the anti-backflow diode 12. In other words, the solder resist 20r has an opening in each of regions in which the photovoltaic cell element 11 or the anti-backflow diode 12 is attached by die bonding.

Therefore, chip solder (not shown) is placed in the opening regions of the solder resist 20r. The photovoltaic cell element 11 and the anti-backflow diode 12 are placed on the chip solder, which is then subjected to a thermal treatment in a solder reflow furnace, whereby the photovoltaic cell element 11 and the anti-backflow diode 12 can be accurately positioned and attached by die bonding.

The interconnect pattern 20p (thin metal plate made of copper) needs to be thick enough to dissipate heat generated by the photovoltaic cell element 11 to the outside (the heat sink 60). In this embodiment, for example, the thickness is 300 µm. This thickness allows dissipation of heat from the interconnect pattern 20p to the receiver baseboard 20 (the heat sink 60).

The receiver baseboard 20 is in the shape of a rectangle. The photovoltaic cell element 11 and the anti-backflow diode 12 are provided at a center of the rectangle. The interconnect patterns 20p are extended from the center in a longitudinal direction, and extended end portions thereof will serve as the connection terminals 20pt that are connected to the outside. By causing the receiver baseboard 20 (the interconnect patterns 20p) to have a rectangular shape extended in the longitudinal direction (extended shape), the area of the receiver baseboard 20 can be reduced compared to when the receiver baseboard 20 has a square shape, resulting in an improvement in productivity and a reduction in cost.

The receiver baseboard 20 has fastening holes 20h that are provided at symmetric positions in the vicinity of a diagonal line of the rectangle. The receiver baseboard 20 also has a notch 20c in one of the long sides of the rectangle. The fastening holes 20h allow the receiver baseboard 20 to be accurately positioned and fastened to the holder 40 and the heat sink 60. Also, the notch 20c can be used to correctly indicate the orientation of the receiver baseboard 20, whereby the receiver baseboard 20 can be easily and correctly handled in the manufacturing process, resulting in an improvement in productivity.

The solder resist 20r having the openings corresponding to the photovoltaic cell element 11 and the anti-backflow diode 12 accurately acts on the photovoltaic cell element 11 and the anti-backflow diode 12 when the solder chip is melted in the solder reflow furnace, whereby the photovoltaic cell element 11 and the anti-backflow diode 12 can be accurately positioned.

FIG. 4 is a perspective view of the concentrator photovoltaic module of Embodiment 2 in which the photovoltaic cell has been mounted on the receiver baseboard, for describing a step in the method for manufacturing the concentrator photovoltaic module.

The photovoltaic cell 10 is mounted onto the receiver baseboard 20. Specifically, the photovoltaic cell 10 (the photovoltaic cell element 11) and the receiver baseboard 20 are assembled by a resin confining member forming step, a holder temporarily fixing step, a translucent resin injecting step, a columnar optical member mounting step, and a resin sealing portion forming step described below, thereby mounting and forming the photovoltaic cell 10 on the receiver baseboard 20.

After the baseboard preparing step, the inner resin confining member 23 is formed around the photovoltaic cell element 11 mounted on the receiver baseboard 20 (resin confining member forming step). The inner resin confining member 23 is previously formed of a synthetic resin having high heat resistance, such as PPE (Poly Phenylene Ether) or the like, and in the shape of a frame. The inner resin confining member 23 is attached to the receiver baseboard 20 using, for example, an adhesive. The inner resin confining member 23 has a function of separating, on the surface of the receiver baseboard 20, an inner region where the photovoltaic cell element 11 and the anti-backflow diode 12 are provided from an outer region where the connection terminals 20pt are provided.

After the resin confining member forming step, the holder 40 is provided to cover the inner resin confining member 23. Specifically, fastening holes 43h of the holder 40 are positioned to coincide with the fastening holes 20h of the receiver baseboard 20, thereby positioning the holder 40 and the receiver baseboard 20, which are then temporarily fixed to each other (holder temporarily fixing step).

The temporarily fixing is, for example, performed as follows. An adhesive resin is applied to side surfaces of support mounting members 43 and a surface of the receiver baseboard 20, and the receiver baseboard 20 and the holder 40 are lightly attached to each other. Alternatively, a positioning pin (not shown) may be caused to penetrate the fastening hole 20h and the fastening hole 43h, for example.

After the holder temporarily fixing step, a translucent resin for forming the resin sealing portion 25 is injected inside the inner resin confining member 23 to encapsulate the photovoltaic cell element 11 (translucent resin injecting step). Specifically, the translucent resin is injected through the holder 40 (a center space formed by the holder 40 before the columnar optical member 30 abuts the holder 40). Note that the inner resin confining member 23 prevents leakage of the translucent resin forming the resin sealing portion 25.

After the translucent resin injecting step, the columnar optical member 30 is inserted into the center space formed by an abutting frame 41 to abut a sloped surface of the abutting frame 41, thereby mounting and attaching the columnar optical member 30 to the translucent resin (columnar optical member mounting step). In other words, the columnar optical member 30 is positioned by the holder 40.

After the columnar optical member mounting step, the translucent resin is cured to form the resin sealing portion 25 (resin sealing portion forming step). The columnar optical member 30 positioned by the holder 40 is attached to the resin sealing portion 25, and is fixed by the cured resin sealing portion 25. In other words, by forming the resin sealing portion 25, the columnar optical member 30 is reliably attached to the resin sealing portion 25. Also, by heating the translucent resin to an appropriate temperature, defoaming can be performed simultaneously with curing, whereby the resin sealing portion 25 having excellent translucency can be formed.

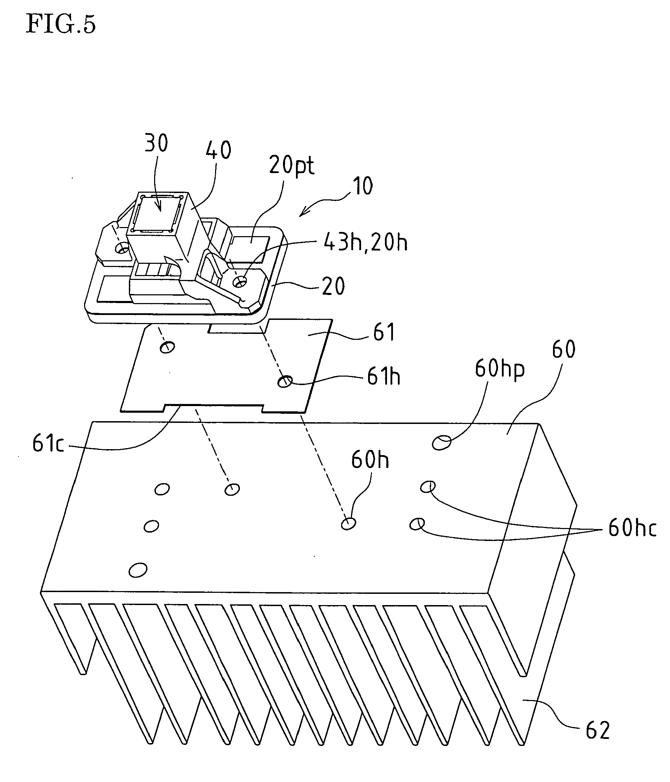

FIG. 5 is an exploded perspective view of the concentrator photovoltaic module of Embodiment 2 before the heat sink is fastened to the receiver baseboard on which the photovoltaic cell is mounted, for describing a step in the method for manufacturing the concentrator photovoltaic module.

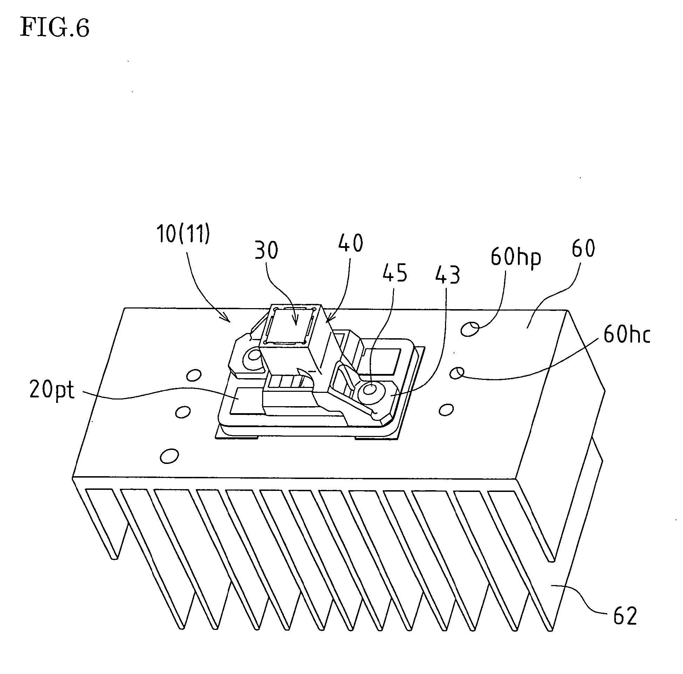

FIG. 6 is an exploded perspective view of the concentrator photovoltaic module of Embodiment 2 after the heat sink is fastened to the receiver baseboard on which the photovoltaic cell is mounted, for describing a step in the method for manufacturing the concentrator photovoltaic module.

After the resin sealing portion forming step, the holder 40 (the photovoltaic cell 10) and the receiver baseboard 20 are fastened to the heat sink 60 by the fastening members 45 (holder fastening step). In other words, the receiver baseboard 20 on which the photovoltaic cell element 11 (the photovoltaic cell 10) is mounted is fastened to the heat sink 60. Note that a heat conductive sheet 61 that is used to tightly attach the receiver baseboard 20 and the heat sink 60 together to improve heat dissipation performance is interposed at an interface between the receiver baseboard 20 and the heat sink 60. A notch 61c for identifying the orientation of the heat conductive sheet 61 is formed in the heat conductive sheet 61. Also, fastening holes 61h through which the fastening members 45 will penetrate are formed in the heat conductive sheet 61.

The fastening members 45 penetrate the fastening holes 43h of the holder 40, the fastening holes 20h of the receiver baseboard 20, the fastening holes 61h of the heat conductive sheet 61, and fastening holes 60h of the heat sink 60, which have been positioned, whereby the holder 40 (the photovoltaic cell 10), the receiver baseboard 20, the heat conductive sheet 61, and the heat sink 60 can be accurately positioned and reliably fastened together.

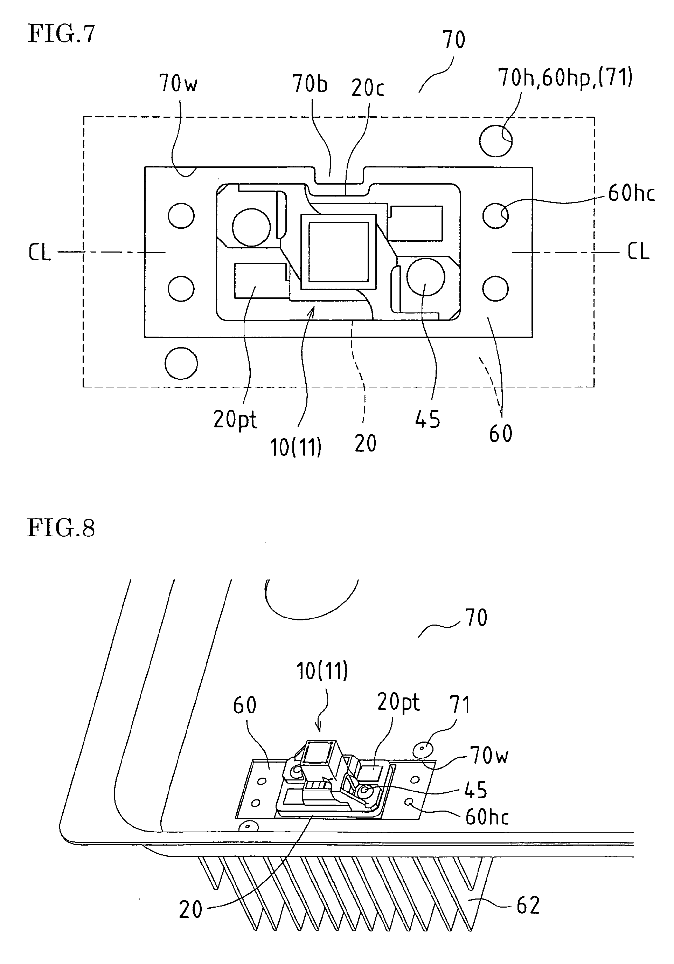

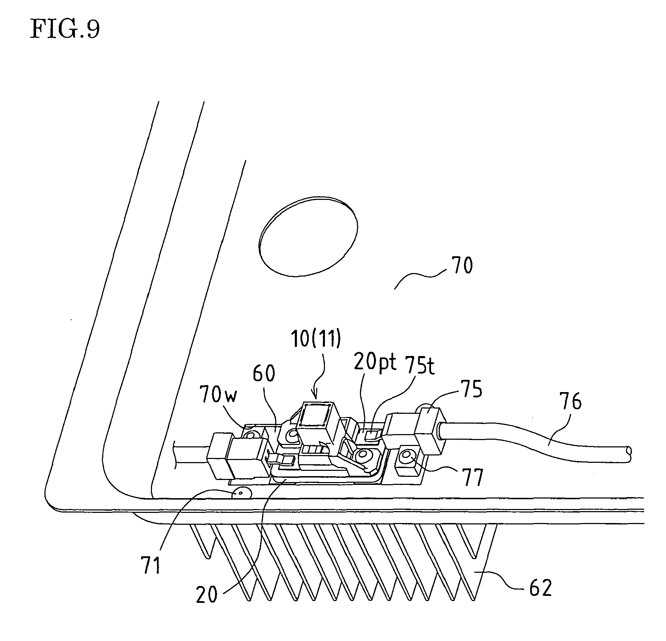

Note that mounting holes 60hp for mounting and fastening the heat sink 60 to the module plate 70 (see FIGS. 7 and 8) are formed in the heat sink 60, and also, connector holes 60hc for fastening connectors 75 (see FIG. 9) are formed in the heat sink 60.

The heat sink 60 has a flat surface larger than the receiver baseboard 20 and is fastened to the receiver baseboard 20. Therefore, the heat sink 60 can effectively dissipate heat coming from the receiver baseboard 20, thereby improving the heat dissipation performance of the receiver baseboard 20. The heat sink 60 also has fins 62 on a surface thereof opposite to that on which the receiver baseboard 20 is provided, and therefore, can further improve the heat dissipation performance.

FIG. 7 is a plan view of the positional relationship between the photovoltaic cell, the receiver baseboard, the openings, the heat sink, and the module plate of the concentrator photovoltaic module of Embodiment 2, for describing a step in the method for manufacturing the concentrator photovoltaic module.

Also, FIG. 8 is a perspective view of the concentrator photovoltaic module of Embodiment 2 in which the heat sink has been fastened to the module plate, for describing a step in the method for manufacturing the concentrator photovoltaic module.

After the holder fastening step, the photovoltaic cell 10 (the photovoltaic cell element 11) and the receiver baseboard 20 are inserted into the opening 70w from the outside of the module plate 70, and the mounting holes 60hp of the heat sink 60 are positioned to coincide with fastening holes 70h of the module plate 70, and the heat sink 60 is fastened to the module plate 70 by the plate fastening members 71. In other words, the photovoltaic cell element 11 (the photovoltaic cell 10) and the receiver baseboard 20 are provided in the opening 70w, the opening 70w is covered with the heat sink 60, and the heat sink 60 is fastened to the module plate 70 around the opening 70w (at the positions of the fastening holes 70h of the module plate 70) (heat sink fastening step).

In the concentrator photovoltaic module 1 of this embodiment, the heat sink 60 is fastened to the module plate 70 by a pair of the plate fastening members 71 located at rotationarily symmetric positions diagonally aligned with respect to a crossing line CL intersecting opposite sides of the opening 70w at the middles thereof at right angles. Therefore, the heat sink 60 can be accurately positioned with respect to the module plate 70.

The plate fastening members 71 are used to position the fastening holes 70h of the module plate 70 and the mounting holes 60hp of the heat sink 60 and fasten the module plate 70 and the heat sink 60 together. In other words, the heat sink 60 is fastened to the module plate 70 by the plate fastening members 71.

Examples of the plate fastening member 71 include rivets, screws, and the like. Note that, when rivets are used, the parts can be easily and accurately fastened together to be firmly fixed to each other, resulting in an improvement in mechanical strength and reliability.

Specifically, by using a rivet as the plate fastening member 71, the heat sink 60 and the module plate 70 can be easily and accurately fastened together to be firmly fixed to each other, resulting in an improvement in mechanical strength and reliability.

Also, as described above, the heat sink 60 is larger than the receiver baseboard 20 and is of a size to cover the opening 70w. Therefore, the photovoltaic cell element 11 (the photovoltaic cell 10) can be accommodated farther inside the concentrator photovoltaic module 1 than the module plate 70 (the heat sink 60), and the heat sink 60 can be provided outside the module plate 70, whereby the reliability of the photovoltaic cell element 11 (the photovoltaic cell 10) can be ensured and the heat dissipation performance can be improved.

Note that, as described above, the receiver baseboard 20 is in the shape of a rectangle, and has the notch 20c in one of the long sides of the rectangle. In this regard, the opening 70w is in the shape of a rectangle corresponding to the receiver baseboard 20, and has a protrusion 70b in one of the long sides of the rectangle, which corresponds to the notch 20c. Therefore, the receiver baseboard 20 can be positioned by easily and accurately identifying the position (orientation) of the receiver baseboard 20 with respect to the module plate 70, resulting in an improvement in productivity.

Also, by causing the width of a short side of the opening 70w to be as close to the width of a short side of the receiver baseboard 20 as possible, the notch 20c and the protrusion 70b can be positioned in a self-aligned manner, resulting in a further improvement in workability.

In the opening 70w, the photovoltaic cell 10 (the photovoltaic cell element 11) and the receiver baseboard 20 are provided, and the connector holes 60hc formed in the heat sink 60 are exposed. Also, the connection terminals 20pt provided on the receiver baseboard 20 are provided at positions corresponding to the connector holes 60hc.

FIG. 9 is a perspective view of the concentrator photovoltaic module of Embodiment 2 in which the connectors have been fastened to the heat sink by connecting connector terminals to the connection terminals.

After the heat sink fastening step, connector terminals 75t are connected to the connection terminals 20pt (connector terminal connecting step), and the connectors 75 are fastened to the heat sink 60 by connector fastening members 77 (connector fastening step).

Thus, the concentrator photovoltaic module 1 of this embodiment includes the connectors 75 having the connector terminals 75t connected to the connection terminal 20pt. The connectors 75 are fastened to the heat sink 60 (the connector holes 60hc) by the connector fastening members 77.

As described above, the concentrator photovoltaic module 1 of this embodiment includes the concentrating lens 50 that concentrates the sunlight Ls, the photovoltaic cell element 11 that converts the sunlight Ls concentrated by the concentrating lens 50 into electricity, the receiver baseboard 20 on which the photovoltaic cell element 11 (the photovoltaic cell 10) is mounted, the heat sink 60 that dissipates heat coming from the receiver baseboard 20, the module plate 70 to which the heat sink 60 is attached, and the opening 70w that is formed in the module plate 70 and in which the photovoltaic cell element 11 (the photovoltaic cell 10) and the receiver baseboard 20 are provided. The receiver baseboard 20 is fastened to the heat sink 60 by the fastening members 45, and the heat sink 60 is fastened to the module plate 70 around the opening 70w by the plate fastening members 71.

Also, the concentrator photovoltaic module 1 of this embodiment includes the connection terminals 20pt that are formed on the receiver baseboard 20 and through which generated power is extracted from the photovoltaic cell element 11, and the connectors 75 having the connector terminals 75t connected to the connection terminals 20pt. The connectors 75 are fastened to the heat sink 60 by the connector fastening members 77.

Therefore, the connectors 75 can be accurately and firmly fixed to the heat sink 60, and the connector terminals 75t can be accurately and firmly connected to the connection terminals 20pt, whereby the connection strength of the connectors 75 can be improved, resulting in an improvement in connection reliability.

Note that the connection terminal 20pt and the connector terminal 75t can be connected together using, for example, solder. Also, the connector 75 includes a connector lead 76 for external connection.

Also, examples of the connector fastening member 77 include rivets, screws, and the like. Note that, when rivets are used, the parts can be easily and accurately fastened together to be firmly fixed to each other, resulting in an improvement in mechanical strength and reliability.

As described above, the concentrator photovoltaic module manufacturing method of this embodiment is a method for manufacturing the concentrator photovoltaic module 1 including the concentrating lens 50 that concentrates the sunlight Ls, the photovoltaic cell element 11 (the photovoltaic cell 10) that converts the sunlight Ls concentrated by the concentrating lens 50 into electricity, the receiver baseboard 20 on which the photovoltaic cell element 11 is mounted, the heat sink 60 that dissipates heat coming from the receiver baseboard 20, the module plate 70 to which the heat sink 60 is attached, the opening 70w that is formed in the module plate 70 and in which the photovoltaic cell element 11 and the receiver baseboard 20 are provided, the connection terminals 20pt that are formed on the receiver baseboard 20 and through which generated power is extracted from the photovoltaic cell element 11, and the connectors 75 having the connector terminals 75t connected to the connection terminals 20pt.

Also, the concentrator photovoltaic module manufacturing method of this embodiment includes the step of fastening the receiver baseboard 20 to the heat sink 60 (holder fastening step), the step of placing the photovoltaic cell element 11 (the photovoltaic cell 10) and the receiver baseboard 20 in the opening 70w and covering the opening 70w with the heat sink 60, the step of fastening the heat sink 60 to the module plate 70 around the opening 70w (heat sink fastening step), the step of connecting the connector terminals 75t to the connection terminals 20pt, and fastening the connectors 75 to the heat sink 60 (connector terminal connecting step, connector fastening step).

Therefore, the heat sink 60 and the receiver baseboard 20 can be accurately positioned and firmly fixed to the module plate 70, and the connectors 75 can be accurately positioned and firmly fixed to the heat sink 60. Therefore, the concentrator photovoltaic module 1 in which the photovoltaic cell element 11 (the photovoltaic cell 10) and the connectors 75 are accurately positioned and firmly fixed, and the heat dissipation performance and the reliability are improved, can be manufactured with high workability.

### <Embodiment 3>

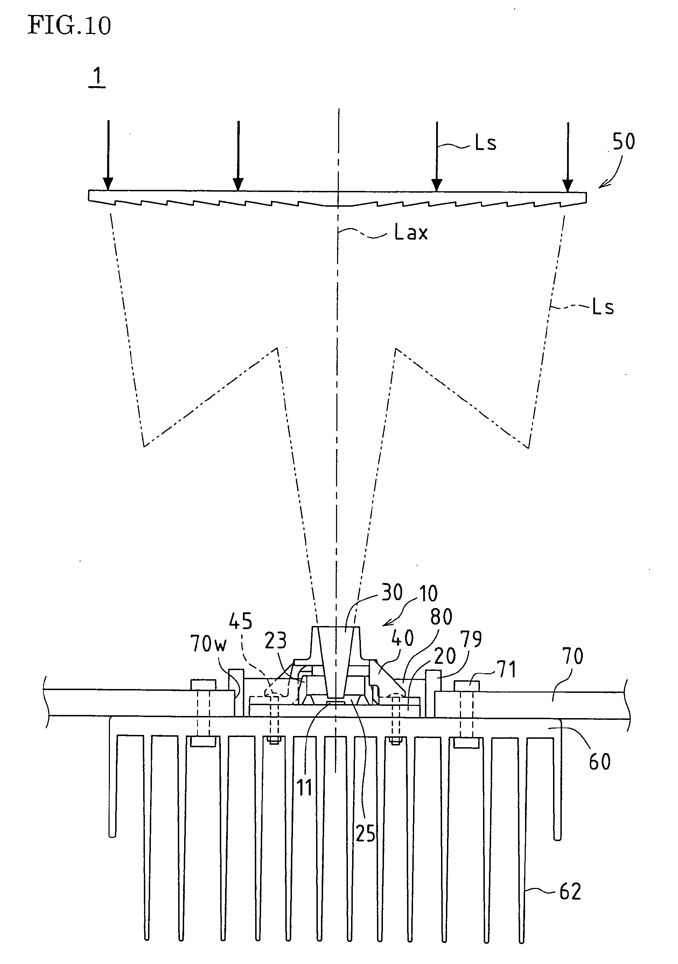

Next, a concentrator photovoltaic module according to Embodiment 3 and a method for manufacturing the concentrator photovoltaic module will be described with reference to FIGS. 10-14. Note that the concentrator photovoltaic module 1 of this embodiment includes the same components as those of the concentrator photovoltaic modules 1 of Embodiments 1 and 2 and therefore will also be described with reference to FIGS. 2-8 described above when necessary.

FIG. 10 is a see-through side view schematically showing a structure of the concentrator photovoltaic module of Embodiment 3, taken along a plane including an optical axis.

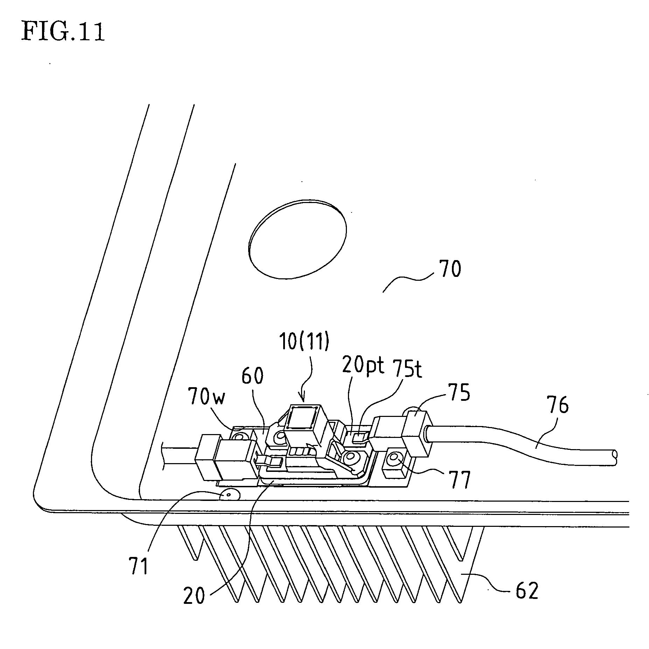

FIG. 11 is a perspective view of the concentrator photovoltaic module of Embodiment 3 after connector terminals are connected to connection terminals, connectors are fastened to a heat sink, and the heat sink is fastened to a module plate and before a receiver resin sealing portion is formed, for describing a step in the method for manufacturing the concentrator photovoltaic module.

The concentrator photovoltaic module 1 of this embodiment includes a concentrating lens 50 that concentrates sunlight Ls incident from the direction of an optical axis Lax, a photovoltaic cell element 11 that converts the sunlight Ls concentrated by the concentrating lens 50 into electricity, a receiver baseboard 20 on which the photovoltaic cell element 11 is mounted, a heat sink 60 that dissipates heat coming from the receiver baseboard 20, and a module plate 70 attached to the heat sink 60.

Also, the concentrator photovoltaic module 1 includes an opening 70w that is formed in the module plate 70 and in which the photovoltaic cell element 11 and the receiver baseboard 20 are provided, connection terminals 20pt (not shown in FIG. 10) that is formed on the receiver baseboard 20 and through which generated power is extracted from the photovoltaic cell element 11, connectors 75 (not shown in FIG. 10) having connector terminals 75t (not shown in FIG. 10) connected to the connection terminals 20pt, and a receiver resin sealing portion 80 that covers the connection terminals 20pt, the connector terminals 75t, and the receiver baseboard 20.

The receiver baseboard 20 is fastened to the heat sink 60 by fastening members 45. The heat sink 60 of a size to cover the opening 70w is fastened to the module plate 70 around the opening 70w by the plate fastening members 71. Also, the connectors 75 are fastened to the heat sink 60 by connector fastening members 77, and include connector leads 76 for external connection. Note that the connection terminal 20pt and the connector terminal 75t can be connected together using, for example, solder.

Therefore, the receiver baseboard 20 and the heat sink 60 are fastened together. The heat sink 60 and the module plate 70 are fastened together. The connectors 75 and the heat sink 60 are fastened together. Surfaces of the connection terminals 20pt, the connector terminals 75t, and the receiver baseboard 20 are covered with the receiver resin sealing portion 80. As a result, the photovoltaic cell element 11 (the photovoltaic cell 10) can be accurately positioned and firmly fixed to the module plate 70, whereby a region that electronically functions of the surface of the receiver baseboard 20 can be shut off from an ambient environment (water, moisture, etc.). Therefore, the influence of the ambient environment on the connection terminals 20pt, the connector terminals 75t, and the receiver baseboard 20 can be prevented, thereby providing the concentrator photovoltaic module 1 in which the insulating property and weatherability (water resistance and contamination resistance) of the connection terminals 20pt, the connector terminals 75t, and the receiver baseboard 20 can be improved, and the mechanical strength, the heat dissipation performance, and the reliability can be improved.

Note that the photovoltaic cell 10 includes the photovoltaic cell element 11, a columnar optical member 30 that brings the concentrated sunlight Ls to the photovoltaic cell element 11, a holder 40 that holds the columnar optical member 30, and a resin sealing portion 25 that protects a surface of the photovoltaic cell element 11 and with which a space between the photovoltaic cell element 11 and the columnar optical member 30 is filled.

The connection terminals 20pt through which generated power is extracted from the photovoltaic cell element 11 are formed on the receiver baseboard 20. Also, the photovoltaic cell element 11 is encapsulated by the resin sealing portion 25 that is confined by an inner resin confining member 23. The resin sealing portion 25 is formed of a translucent resin with which the space between the photovoltaic cell element 11 and the columnar optical member 30 is filled. Examples of the translucent resin include epoxy resins, silicone resins, and the like.

The columnar optical member 30 is arranged to face the photovoltaic cell element 11. The columnar optical member 30, which is held by the holder 40, guides the concentrated sunlight Ls to the photovoltaic cell element 11. The holder 40 is fastened to the receiver baseboard 20 and the heat sink 60 by the fastening members 45 fastening the receiver baseboard 20 and the heat sink 60 together.

Thermal energy of the concentrated sunlight Ls applied to the columnar optical member 30 is dissipated via the holder 40 and the receiver baseboard 20 to the heat sink 60, whereby heat dissipation characteristics can be improved. Also, the holder 40 can dissipate, via the receiver baseboard 20 and the heat sink 60, thermal energy that is applied to the holder 40 by an unnecessary portion having a long wavelength of the sunlight Ls.

Specifically, the holder 40 abuts the receiver baseboard 20 outside the columnar optical member 30 (at a position away from the photovoltaic cell element 11), and therefore, can dissipate heat while reducing the influence on the photovoltaic cell element 11. Therefore, the heat dissipation performance of the photovoltaic cell 10 (the photovoltaic cell element 11 and the holder 40) can be improved.

The heat sink 60 is larger than the receiver baseboard 20 and is of a size to cover the opening 70w. Also, the heat sink 60 is provided farther outside than the module plate 70 (i.e., exposed to the outside).

Specifically, the photovoltaic cell element 11 (the photovoltaic cell 10) and the receiver baseboard 20 can be accommodated farther inside the concentrator photovoltaic module 1 than the module plate 70 (the heat sink 60) (i.e., can be located in a space between the concentrating lens 50 and the heat sink 60), and the heat sink 60 can be provided outside the module plate 70, whereby the reliability of the photovoltaic cell 10 can be ensured and the heat dissipation performance can be improved. Note that the heat sink 60 has fins 62 protruding outside the module plate 70, whereby the heat dissipation performance can be improved.

The fastening members 45 fasten the holder 40, the receiver baseboard 20, and the heat sink 60 together. The plate fastening members 71 fasten the heat sink 60 and the module plate 70 together. Also, the connector fastening members 77 fasten the heat sink 60 and the connector 75 together.

Also, examples of the fastening member 45, the plate fastening member 71, and the connector fastening member 77 include rivets, screws, and the like. Note that, when rivets are used, the parts can be easily and accurately fastened together to be firmly fixed to each other, resulting in an improvement in mechanical strength and reliability.

The concentrator photovoltaic module 1 of this embodiment includes an outer resin confining member 79 that is provided along an outer circumference of the receiver baseboard 20 and has a top portion higher than the position of the connector terminal 75t. A receiver resin sealing portion 80 is formed between the inner resin confining member 23 and the outer resin confining member 79.

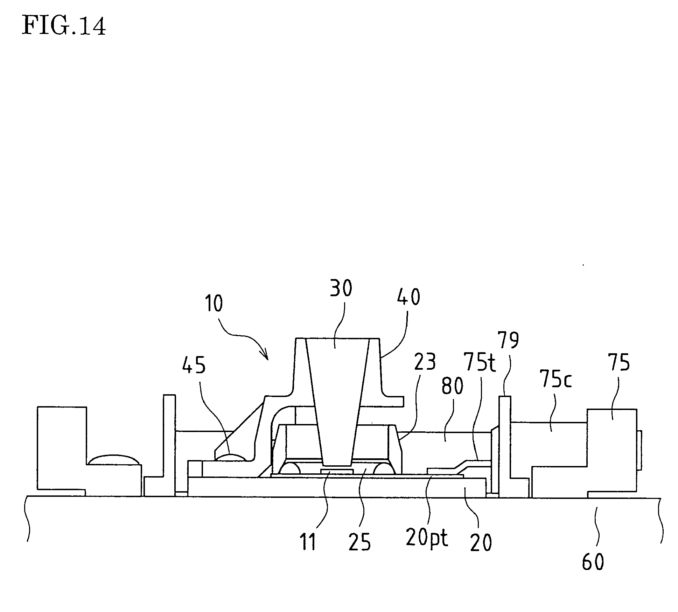

Specifically, the concentrator photovoltaic module 1 of this embodiment includes the inner resin confining member 23 that is provided around the resin sealing portion 25 encapsulating the photovoltaic cell element 11 and confines the resin sealing portion 25, and the outer resin confining member 79 that is provided along the outer circumference of the receiver baseboard 20 and has the top portion higher than the position of the connector terminal 75t. Also, the receiver resin sealing portion 80 is formed between the inner resin confining member 23 and the outer resin confining member 79 and is lower than the top portion of the inner resin confining member 23 (see FIG. 14). Therefore, an insulating resin of the receiver resin sealing portion 80 is prevented from leaking into the inside of the inner resin confining member 23.

Therefore, a region where the receiver resin sealing portion 80 is formed (a region filled with the insulating resin) can be accurately demarcated, and the influence of the receiver resin sealing portion 80 on the optical characteristics of the photovoltaic cell 10 (the columnar optical member 30) can be reliably eliminated. Therefore, high light concentration characteristics and reliability can be imparted to the concentrator photovoltaic module 1.

In the concentrator photovoltaic module manufacturing method of this embodiment, initially, the photovoltaic cell element 11 is mounted onto the receiver baseboard 20. Specifically, the photovoltaic cell element 11 and an anti-backflow diode 12 are attached by die bonding to the interconnect patterns 20p formed on the receiver baseboard 20, and wires 13 are attached to the photovoltaic cell element 11, the anti-backflow diode 12, and the interconnect patterns 20p by wire bonding (baseboard preparing step, see FIG. 3). Note that the photovoltaic cell element 11 is made of, for example, a compound semiconductor, and the anti-backflow diode 12 is made of, for example, a silicon single crystal.

The interconnect patterns 20p are provided corresponding to positive and negative electrodes of the photovoltaic cell element 11 and the anti-backflow diode 12. For example, the interconnect pattern 20p to which the photovoltaic cell element 11 and the anti-backflow diode 12 are attached by die bonding is a positive electrode, while the interconnect pattern 20p to which the photovoltaic cell element 11 and the anti-backflow diode 12 are connected by wire bonding is a negative electrode.

The interconnect patterns 20p are formed of a thin metal plate made of copper formed on an insulating film 20i formed on a surface of the receiver baseboard 20. On the interconnect pattern 20p that will serve as a positive electrode, a solder resist 20r is formed around the photovoltaic cell element 11 and the anti-backflow diode 12. In other words, the solder resist 20r has an opening in each of regions in which the photovoltaic cell element 11 or the anti-backflow diode 12 is attached by die bonding.

Therefore, chip solder (not shown) is placed in the opening regions of the solder resist 20r. The photovoltaic cell element 11 and the anti-backflow diode 12 are placed on the chip solder, which is then subjected to a thermal treatment in a solder reflow furnace, whereby the photovoltaic cell element 11 and the anti-backflow diode 12 can be accurately positioned and attached by die bonding.

The interconnect pattern 20p (thin metal plate made of copper) needs to be thick enough to dissipate heat generated by the photovoltaic cell element 11 to the outside (the heat sink 60). In this embodiment, for example, the thickness is 300 µm. This thickness allows dissipation of heat from the interconnect pattern 20p to the receiver baseboard 20 (the heat sink 60).

The receiver baseboard 20 is in the shape of a rectangle. The photovoltaic cell element 11 and the anti-backflow diode 12 are provided at a center of the rectangle. The interconnect patterns 20p are extended from the center in a longitudinal direction, and extended end portions thereof will serve as the connection terminals 20pt that are connected to the outside. By causing the receiver baseboard 20 (the interconnect patterns 20p) to have a rectangular shape extended in the longitudinal direction (extended shape), the area of the receiver baseboard 20 can be reduced compared to when the receiver baseboard 20 has a square shape, resulting in an improvement in productivity and a reduction in cost.

The receiver baseboard 20 has fastening holes 20h that are provided at symmetric positions in the vicinity of a diagonal line of the rectangle. The receiver baseboard 20 also has a notch 20c in one of the long sides of the rectangle. The fastening holes 20h allow the receiver baseboard 20 to be accurately positioned and fastened to the holder 40 and the heat sink 60. Also, the notch 20c can be used to correctly indicate the orientation of the receiver baseboard 20, whereby the receiver baseboard 20 can be easily and correctly handled in the manufacturing process, resulting in an improvement in productivity.

The solder resist 20r having the openings corresponding to the photovoltaic cell element 11 and the anti-backflow diode 12 accurately acts on the photovoltaic cell element 11 and the anti-backflow diode 12 when the solder chip is melted in the solder reflow furnace, whereby the photovoltaic cell element 11 and the anti-backflow diode 12 can be accurately positioned.

Next, the photovoltaic cell 10 is mounted onto the receiver baseboard 20 (see FIG. 4). Specifically, the photovoltaic cell 10 (the photovoltaic cell element 11) and the receiver baseboard 20 are assembled by a resin confining member forming step, a holder temporarily fixing step, a translucent resin injecting step, a columnar optical member mounting step, and a resin sealing portion forming step described below, thereby mounting (forming) the photovoltaic cell 10 onto the receiver baseboard 20.

After the baseboard preparing step, the inner resin confining member 23 is formed around the photovoltaic cell element 11 mounted on the receiver baseboard 20 (resin confining member forming step). The inner resin confining member 23 is previously formed of a synthetic resin, such as PPE (Poly Phenylene Ether) or the like, in the shape of a frame. The inner resin confining member 23 is attached to the receiver baseboard 20 using, for example, an adhesive. The inner resin confining member 23 has a function of separating, on the surface of the receiver baseboard 20, an inner region where the photovoltaic cell element 11 and the anti-backflow diode 12 are provided from an outer region where the connection terminals 20pt are provided.

After the resin confining member forming step, the holder 40 is provided to cover the inner resin confining member 23. Specifically, fastening holes 43h of the holder 40 are positioned to coincide with the fastening holes 20h of the receiver baseboard 20, thereby positioning the holder 40 and the receiver baseboard 20, which are then temporarily fixed to _ each other (holder temporarily fixing step).

The temporarily fixing is, for example, performed as follows. An adhesive resin is applied to side surfaces of support mounting members 43 and a surface of the receiver baseboard 20, and the receiver baseboard 20 and the holder 40 are lightly attached to each other. Alternatively, a positioning pin (not shown) may be caused to penetrate the fastening hole 20h and the fastening hole 43h, for example.

After the holder temporarily fixing step, a translucent resin for forming the resin sealing portion 25 is injected inside the inner resin confining member 23 to encapsulate the photovoltaic cell element 11 (translucent resin injecting step). Specifically, the translucent resin is injected through the holder 40 (a center space formed by the holder 40 before the columnar optical member 30 abuts the holder 40). Note that the inner resin confining member 23 prevents leakage of the translucent resin forming the resin sealing portion 25.

After the translucent resin injecting step, the columnar optical member 30 is inserted into the center space formed by an abutting frame 41 to abut a sloped surface of the abutting frame 41, thereby mounting and attaching the columnar optical member 30 to the translucent resin (columnar optical member mounting step). In other words, the columnar optical member 30 is positioned by the holder 40.

After the columnar optical member mounting step, the translucent resin is cured to form the resin sealing portion 25 (resin sealing portion forming step). The columnar optical member 30 positioned by the holder 40 is attached to the resin sealing portion 25, and is fixed by the cured resin sealing portion 25. In other words, by forming the resin sealing portion 25, the columnar optical member 30 is reliably attached to the resin sealing portion 25. Also, by heating the translucent resin to an appropriate temperature, defoaming can be performed simultaneously with curing, whereby the resin sealing portion 25 having excellent translucency can be formed.

After the resin sealing portion forming step, the holder 40 (the photovoltaic cell 10) and the receiver baseboard 20 are fastened to the heat sink 60 by the fastening members 45 (holder fastening step, see FIGS. 5 and 6). In other words, the receiver baseboard 20 on which the photovoltaic cell element 11 (the photovoltaic cell 10) is mounted is fastened to the heat sink 60. Note that a heat conductive sheet 61 that is used to tightly attach the receiver baseboard 20 and the heat sink 60 together to improve heat dissipation performance is interposed at an interface between the receiver baseboard 20 and the heat sink 60. A notch 61c for identifying the orientation of the heat conductive sheet 61 is formed in the heat conductive sheet 61. Also, fastening holes 61h through which the fastening members 45 will penetrate are formed in the heat conductive sheet 61.

The fastening members 45 penetrate the fastening holes 43h of the holder 40, the fastening holes 20h of the receiver baseboard 20, the fastening holes 61h of the heat conductive sheet 61, and fastening holes 60h of the heat sink 60, which have been positioned, whereby the holder 40 (the photovoltaic cell 10), the receiver baseboard 20, the heat conductive sheet 61, and the heat sink 60 can be accurately positioned and reliably fastened together.

Note that mounting holes 60hp for mounting and fastening the heat sink 60 to the module plate 70 (see FIGS. 7 and 8) are formed in the heat sink 60, and also, connector holes 60hc for fastening the connectors 75 (see FIG. 11) are formed in the heat sink 60.

The heat sink 60 has a flat surface larger than the receiver baseboard 20 and is fastened to the receiver baseboard 20. Therefore, the heat sink 60 can effectively dissipate heat coming from the receiver baseboard 20, thereby improving the heat dissipation performance of the receiver baseboard 20. The heat sink 60 also has fins 62 on a surface thereof opposite to that on which the receiver baseboard 20 is provided, and therefore, can further improve the heat dissipation performance.

After the holder fastening step, the photovoltaic cell 10 (the photovoltaic cell element 11) and the receiver baseboard 20 are inserted into the opening 70w from the outside of the module plate 70, and the mounting holes 60hp of the heat sink 60 are positioned to coincide with fastening holes 70h of the module plate 70, and the heat sink 60 is fastened to the module plate 70 by the plate fastening members 71 (see FIGS. 7 and 8).

In other words, the photovoltaic cell element 11 (the photovoltaic cell 10) and the receiver baseboard 20 are provided in the opening 70w, the opening 70w is covered with the heat sink 60, and the heat sink 60 is fastened to the module plate 70 around the opening 70w (at the positions of the fastening holes 70h of the module plate 70) (heat sink fastening step).

In the concentrator photovoltaic module 1 of this embodiment, the heat sink 60 is fastened to the module plate 70 by a pair of the plate fastening members 71 located at rotationarily symmetric positions diagonally aligned with respect to a crossing line CL intersecting opposite sides of the opening 70w at the middles thereof at right angles. Therefore, the heat sink 60 can be accurately positioned with respect to the module plate 70.

The plate fastening members 71 are used to position the fastening holes 70h of the module plate 70 and the mounting holes 60hp of the heat sink 60 and fasten the module plate 70 and the heat sink 60 together. In other words, the heat sink 60 is fastened to the module plate 70 by the plate fastening members 71.

Note that, as the plate fastening member 71, rivets are preferable. When a rivet is used as the plate fastening member 71, the heat sink 60 and the module plate 70 can be easily and accurately fastened together to be firmly fixed to each other, resulting in an improvement in mechanical strength and reliability.

Also, as described above, the heat sink 60 is larger than the receiver baseboard 20 and is of a size to cover the opening 70w. Therefore, the photovoltaic cell element 11 (the photovoltaic cell 10) can be accommodated farther inside the concentrator photovoltaic module 1 than the module plate 70 (the heat sink 60), and the heat sink 60 can be provided outside the module plate 70, whereby the reliability of the photovoltaic cell element 11 (the photovoltaic cell 10) can be ensured and the heat dissipation performance can be improved.

Also, the receiver baseboard 20 is in the shape of a rectangle, and has the notch 20c in one of the long sides of the rectangle. In this regard, the opening 70w is in the shape of a rectangle corresponding to the receiver baseboard 20, and has a protrusion 70b in one of the long sides of the rectangle, which corresponds to the notch 20c. Therefore, the receiver baseboard 20 can be positioned by easily and correctly identifying the arrangement (orientation) of the receiver baseboard 20 with respect to the module plate 70, resulting in an improvement in productivity.

Also, by causing the width of a short side of the opening 70w to be as close to the width of a short side of the receiver baseboard 20 as possible, the notch 20c and the protrusion 70b can be positioned in a self-aligned manner, resulting in a further improvement in workability.

In the opening 70w, the photovoltaic cell 10 (the photovoltaic cell element 11) and the receiver baseboard 20 are provided, and the connector holes 60hc formed in the heat sink 60 are exposed. Also, the connection terminals 20pt provided on the receiver baseboard 20 are provided at positions corresponding to the connector holes 60hc.

After the heat sink fastening step, the connector terminals 75t are connected to the connection terminals 20pt (connector terminal connecting step, see FIG. 11), and the connectors 75 are fastened to the heat sink 60 by connector fastening members 77 (connector fastening step, see FIG. 11). Note that the assembly after the connector terminal connecting step and the connector fastening step is as shown in FIG. 11.

Thus, the concentrator photovoltaic module 1 of this embodiment includes the connectors 75 having the connector terminals 75t connected to the connection terminal 20pt. The connectors 75 are fastened to the heat sink 60 (the connector holes 60hc) by the connector fastening members 77.

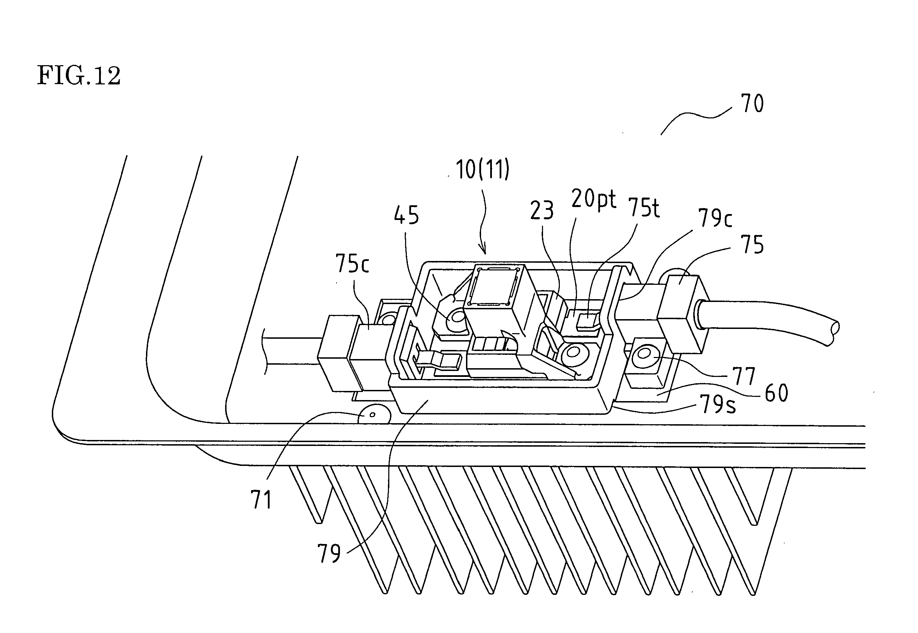

FIG. 12 is a perspective view of the concentrator photovoltaic module of Embodiment 3 in which the outer resin confining member has been engaged with the heat sink and the module plate, for describing a step in the method for manufacturing the concentrator photovoltaic module.

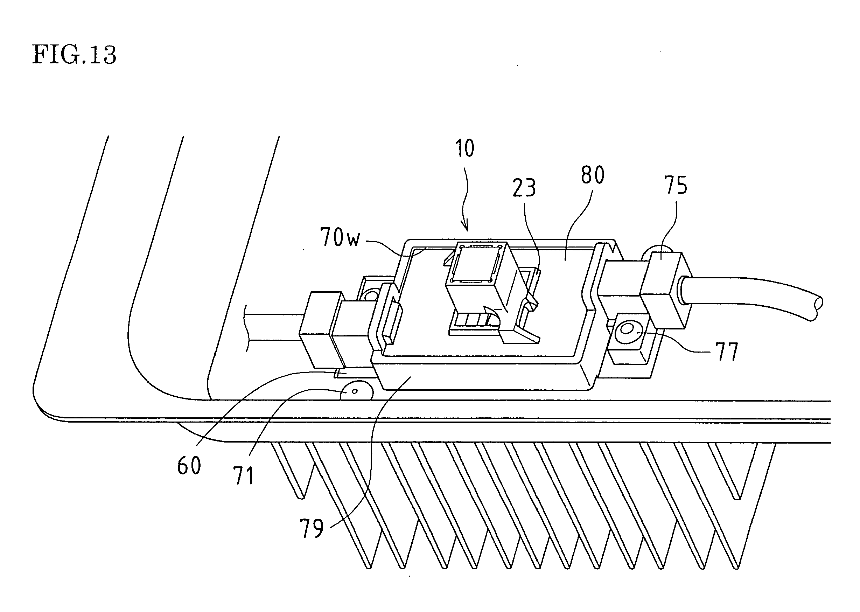

FIG. 13 is a perspective view of the concentrator photovoltaic module of Embodiment 3 in which the receiver resin sealing portion has been formed, for describing a step in the method for manufacturing the concentrator photovoltaic module.

FIG. 14 is a diagram for describing the concept of the relationship in the height direction between the inner resin confining member, the outer resin confining member, and the receiver resin sealing portion in the concentrator photovoltaic module of Embodiment 3.

After the connector terminal connecting step and the connector fastening step are ended, the outer resin confining member 79 is provided. Specifically, the outer resin confining member 79 is engaged (fitted) with the heat sink 60 and the module plate 70 (the opening 70w) (outer resin confining member providing step, see FIG. 12).

After the outer resin confining member providing step, the receiver resin sealing portion 80 is formed to cover the connection terminals 20pt, the connector terminals 75t, and the receiver baseboard 20 (receiver resin sealing portion forming step, see FIG. 13).

The outer resin confining member 79 includes an opening step engaging portion 79s corresponding to a step (a thickness of the opening 70w, i.e., a thickness of the module plate 70) between the heat sink 60 and the module plate 70. Also, the outer resin confining member 79 abuts the heat sink 60 and the opening 70w at the short sides of the receiver baseboard 20, and abuts the module plate 70 at the long sides of the receiver baseboard 20.

Therefore, the outer resin confining member 79 can be engaged (fitted) with the opening 70w so that a bottom portion of the outer resin confining member 79 abuts the heat sink 60 and the module plate 70. As a result, the outer resin confining member 79 prevents the insulating resin of the receiver resin sealing portion 80 from leaking from the outer resin confining member 79, whereby the receiver resin sealing portion 80 can be accurately formed.

Note that the opening step engaging portion 79s is preferably formed at the short sides of the outer resin confining member 79. With this structure, the outer resin confining member 79 can be reliably fitted with the opening 70w along the short side direction.

Also, the bottom portions of the outer resin confining member 79 that abut the heat sink 60 and the module plate 70 can be previously attached to the heat sink 60 and the module plate 70 with an adhesive being interposed therebetween. With this structure, the insulating resin of the receiver resin sealing portion 80 can be reliably prevented from leaking from the outer resin confining member 79 into the outside.

The connector 75 includes a connector housing 75c that holds the connector terminal 75t. The outer resin confining member 79 includes a connector engaging portion 79c that is engaged with the connector housing 75c.

Therefore, the outer resin confining member 79 can be engaged with the connector housing 75c, whereby the insulating resin of the receiver resin sealing portion 80 is prevented from leaking from the outer resin confining member 79 via the connector 75, and therefore, the receiver resin sealing portion 80 can be accurately formed.

The outer resin confining member 79 is provided at an outer circumference of the receiver baseboard 20, has a top portion higher than the position of the connector terminal 75t, and is located closer to the receiver baseboard 20 than the connector 75. Also, as shown in FIG. 10 (and FIG. 2), the photovoltaic cell 10 includes the inner resin confining member 23 that is provided around the resin sealing portion 25 that encapsulates the photovoltaic cell element 11, thereby confining the resin sealing portion 25.

The receiver resin sealing portion 80 is formed between the inner resin confining member 23 and the outer resin confining member 79, and is lower than the top portion of the inner resin confining member 23. Therefore, a region where the receiver resin sealing portion 80 is formed (a region filled with the insulating resin) can be accurately demarcated, and the influence of the receiver resin sealing portion 80 on the optical characteristics of the photovoltaic cell 10 (the columnar optical member 30) can be reliably eliminated. Therefore, high light concentration characteristics and reliability can be imparted to the concentrator photovoltaic module 1.

The receiver resin sealing portion 80 needs to cover the connection terminals 20pt and the connector terminals 75t. Also, the inner resin confining member 23 needs to function to prevent leakage of the insulating resin of the receiver resin sealing portion 80. Specifically, the top portion of the inner resin confining member 23 needs to be higher than the connection terminals 20pt and the connector terminals 75t.

The resin sealing portion 25 provides encapsulation to impart an optical characteristic, and the receiver resin sealing portion 80 provides encapsulation to impart an insulating property. Therefore, a resin suitable for the intended action needs to be selected for each encapsulation. Also, as described above, the resin sealing portion 25 is demarcated by the inner resin confining member 23, and the receiver resin sealing portion 80 is demarcated by the outer resin confining member 79 and the inner resin confining member 23. Therefore, the translucent resin of the resin sealing portion 25 and the insulating resin of the receiver resin sealing portion 80 are not mixed, and therefore, the concentrator photovoltaic module 1 can be easily manufactured with high workability and a high yield.

Note that the outer resin confining member 79 is preferably previously formed in the shape of a frame. With this structure, it is not necessary to use a jig in order to form the receiver resin sealing portion 80, whereby the outer resin confining member 79 can be accurately formed, and therefore, the receiver resin sealing portion 80 can be easily and accurately formed. The outer resin confining member 79 can be made of the same material as that of the inner resin confining member 23.

Also, by previously forming the receiver resin sealing portion 80 in the shape of a frame, the bottom portion of the outer resin confining member 79 can be easily attached to the heat sink 60 and the module plate 70 before the insulating resin for forming the receiver resin sealing portion 80 is injected. Therefore, the insulating resin of the receiver resin sealing portion 80 can be prevented from leaking into the outside.

As described above, the concentrator photovoltaic module 1 of this embodiment includes the concentrating lens 50 that concentrates the sunlight Ls, the photovoltaic cell element 11 that converts the sunlight Ls concentrated by the concentrating lens 50 into electricity, the receiver baseboard 20 on which the photovoltaic cell element 11 (the photovoltaic cell 10) is mounted, the heat sink 60 that dissipates heat coming from the receiver baseboard 20, the module plate 70 to which the heat sink 60 is attached, the opening 70w that is formed in the module plate 70 and in which the photovoltaic cell element 11 (the photovoltaic cell 10) and the receiver baseboard 20 are provided, the connection terminals 20pt that are formed on the receiver baseboard 20 and through which generated power is extracted from the photovoltaic cell element 11, the connectors 75 having the connector terminals 75t connected to the connection terminals 20pt, and the receiver resin sealing portion 80 that covers the connection terminals 20pt, the connector terminals 75t, and the receiver baseboard 20.

Also, the receiver baseboard 20 is fastened to the heat sink 60. The heat sink 60 of a size to cover the opening 70w is fastened to the module plate 70 around the opening 70w. The connectors 75 are fastened to the heat sink 60.

Therefore, the receiver baseboard 20 and the heat sink 60 are fastened together. The heat sink 60 and the module plate 70 are fastened together. The connectors 75 and the heat sink 60 are fastened together. Surfaces of the connection terminals 20pt, the connector terminals 75t, and the receiver baseboard 20 are covered with the receiver resin sealing portion 80.

Therefore, the photovoltaic cell element 11 (the photovoltaic cell 10) can be accurately positioned and firmly fixed to the module plate 70, whereby a region that electronically functions of the surface of the receiver baseboard 20 can be shut off from an ambient environment (water, moisture, etc.). Therefore, the influence of the ambient environment on the connection terminals 20pt, the connector terminals 75t, and the receiver baseboard 20 can be prevented, thereby providing the concentrator photovoltaic module 1 in which the insulating property and weatherability (water resistance and contamination resistance) of the connection terminals 20pt, the connector terminals 75t, and the receiver baseboard 20 can be improved, and the mechanical strength, the heat dissipation performance, and the reliability can be improved.

As described above, the concentrator photovoltaic module manufacturing method of this embodiment is a method for manufacturing the concentrator photovoltaic module 1 including the concentrating lens 50 that concentrates the sunlight Ls, the photovoltaic cell element 11 (the photovoltaic cell 10) that converts the sunlight Ls concentrated by the concentrating lens 50 into electricity, the receiver baseboard 20 on which the photovoltaic cell element 11 is mounted, the heat sink 60 that dissipates heat coming from the receiver baseboard 20, the module plate 70 to which the heat sink 60 is attached, the opening 70w that is formed in the module plate 70 and in which the photovoltaic cell element 11 and the receiver baseboard 20 are provided, the connection terminals 20pt that are formed on the receiver baseboard 20 and through which generated power is extracted from the photovoltaic cell element 11, the connectors 75 having the connector terminals 75t connected to the connection terminals 20pt, and the receiver resin sealing portion 80 that covers the connection terminals 20pt, the connector terminals 75t, and the receiver baseboard 20.

Also, the concentrator photovoltaic module manufacturing method of this embodiment includes the step of fastening the receiver baseboard 20 to the heat sink 60 (holder fastening step), the step of placing the photovoltaic cell element 11 (the photovoltaic cell 10) and the receiver baseboard 20 in the opening 70w and covering the opening 70w with the heat sink 60, the step of fastening the heat sink 60 to the module plate 70 around the opening 70w (heat sink fastening step), the step of connecting the connector terminals 75t to the connection terminals 20pt, and fastening the connectors 75 to the heat sink 60 (connector terminal connecting step, connector fastening step), and the step of forming the receiver resin sealing portion 80 that covers the connection terminals 20pt, the connector terminals 75t, and the receiver baseboard 20 (receiver resin sealing portion forming step).

Therefore, the receiver baseboard 20, the heat sink 60, the module plate 70, and the connectors 75 are accurately positioned and firmly fixed, and the influence of the ambient environment on the connection terminals 20pt, the connector terminals 75t, and the receiver baseboard 20 can be prevented, thereby providing the concentrator photovoltaic module 1 in which the insulating property and weatherability (water resistance and contamination resistance) of the connection terminals 20pt, the connector terminals 75t, and the receiver baseboard 20 can be improved, and the mechanical strength, the heat dissipation performance, and the reliability can be improved.

The present invention can be embodied and practiced in other different forms without departing from the spirit and essential characteristics thereof. Therefore, the above-described embodiments are considered in all respects as illustrative and not restrictive. The scope of the invention is indicated by the appended claims rather than by the foregoing description. All variations and modifications falling within the equivalency range of the appended claims are intended to be embraced therein.

This application claims priority on Patent Application No. 2008-230261 filed in Japan on September 8, 2008 and Patent Application No. 2008-230262 filed in Japan on September 8, 2008, which are hereby incorporated by reference in its entirety. All documents cited herein are also specifically incorporated by reference in their entirety.

### Industrial Applicability

The present invention is applicable to concentrator photovoltaic modules and methods for manufacturing the concentrator photovoltaic modules.

### Description of Reference Characters

- 1: concentrator photovoltaic module
- 10: photovoltaic cell
- 11: photovoltaic cell element
- 20: receiver baseboard
- 20p: interconnect pattern
- 20pt: connection terminal
- 20h: fastening hole
- 23: inner resin confining member
- 25: resin sealing portion
- 30: columnar optical member
- 40: holder
- 43h: fastening hole
- 45: fastening member
- 50: concentrating lens
- 60: heat sink
- 60h: fastening hole
- 60hc: connector hole
- 60hp: mounting hole
- 61: heat conductive sheet
- 61h: fastening hole
- 62: fin
- 70: module plate
- 70b: protrusion
- 70h: fastening hole
- 70w: opening
- 71: plate fastening member
- 75: connector
- 75t: connector terminal
- 76: connector lead
- 77: connector fastening member
- 79: outer resin confining member
- 79c: connector engaging portion
- 79s: opening step engaging portion
- 80: receiver resin sealing portion
- CL: crossing line
- Lax: optical axis
- Ls: sunlight

## Claims

1. A concentrator photovoltaic module comprising:
a concentrating lens configured to concentrate sunlight;
a photovoltaic cell element configured to convert the sunlight concentrated by the concentrating lens into electricity;
a receiver baseboard on which the photovoltaic cell element is mounted;
a heat sink configured to dissipate heat coming from the receiver baseboard;
a module plate to which the heat sink is attached; and
an opening that is formed in the module plate and in which the photovoltaic cell element and the receiver baseboard are provided,
wherein the receiver baseboard is fastened to the heat sink, and the heat sink is fastened to the module plate around the opening.

2. The concentrator photovoltaic module according to claim 1, comprising:
a connection terminal that is formed on the receiver baseboard and through which generated power is extracted from the photovoltaic cell element; and
a connector having and a connector terminal connected to the connection terminal,
wherein the connector is fastened to the heat sink.

3. The concentrator photovoltaic module according to claim 2, wherein
the heat sink is larger than the receiver baseboard and is of a size to cover the opening.

4. The concentrator photovoltaic module according to claim 1, wherein
the heat sink is fastened to the module plate by a pair of plate fastening members provided at rotationally symmetric positions diagonally aligned with respect to a crossing line intersecting opposite sides of the opening at middles of the sides at right angles.

5. The concentrator photovoltaic module according to claim 4, wherein
the plate fastening member is a rivet.

6. The concentrator photovoltaic module according to any one of claims 2-5, wherein
the connector is fastened to the heat sink by a connector fastening member.

7. The concentrator photovoltaic module according to any one of claims 1-5, wherein
the receiver baseboard is in the shape of a rectangle and has a notch in one of the long sides of the rectangle, and
the opening is in the shape of a rectangle corresponding to the receiver baseboard and has a protrusion corresponding to the notch in one of the long sides of the rectangle.

8. The concentrator photovoltaic module according to claim 2 or 3, further comprising:
a receiver resin sealing portion configured to cover the connection terminal, the connector terminal, and the receiver baseboard.

9. The concentrator photovoltaic module according to claim 8, comprising:
an inner resin confining member provided around a resin sealing portion configured to encapsulate the photovoltaic cell element, and configured to confine the resin sealing portion; and
an outer resin confining member provided at an outer circumference of the receiver baseboard and having a top portion higher than a position of the connector terminal,
wherein the receiver resin sealing portion is formed between the inner resin confining member and the outer resin confining member and is lower than a top portion of the inner resin confining member.

10. The concentrator photovoltaic module according to claim 9, wherein
the outer resin confining member is previously formed in the shape of a frame.

11. The concentrator photovoltaic module according to claim 10, wherein
the receiver baseboard is in the shape of a rectangle, and
the outer resin confining member includes an opening step engaging portion corresponding to a step between the heat sink and the module plate, and abuts the heat sink and the opening at short sides of the receiver baseboard, and abuts the module plate at long sides of the receiver baseboard.

12. The concentrator photovoltaic module according to claim 10, wherein
the connector includes a connector housing configured to hold the connector terminal, and
the outer resin confining member includes a connector engaging portion configured to engage with the connector housing.

13. A method for manufacturing a concentrator photovoltaic module comprising a concentrating lens configured to concentrate sunlight, a photovoltaic cell element configured to convert the sunlight concentrated by the concentrating lens into electricity, a receiver baseboard on which the photovoltaic cell element is mounted, a heat sink configured to dissipate heat coming from the receiver baseboard, a module plate to which the heat sink is attached, an opening that is formed in the module plate and in which the photovoltaic cell element and the receiver baseboard are provided, a connection terminal that is formed on the receiver baseboard and through which generated power is extracted from the photovoltaic cell element, and a connector having a connector terminal connected to the connection terminal, the method comprising the steps of:
fastening the receiver baseboard to the heat sink;
placing the photovoltaic cell element and the receiver baseboard in the opening, covering the opening with the heat sink, and fastening the heat sink to the module plate around the opening; and
connecting the connector terminal to the connection terminal and fastening the connector to the heat sink.

14. A method for manufacturing a concentrator photovoltaic module comprising a concentrating lens configured to concentrate sunlight, a photovoltaic cell element configured to convert the sunlight concentrated by the concentrating lens into electricity, a receiver baseboard on which the photovoltaic cell element is mounted, a heat sink configured to dissipate heat coming from the receiver baseboard, a module plate to which the heat sink is attached, an opening that is formed in the module plate and in which the photovoltaic cell element and the receiver baseboard are provided, a connection terminal that is formed on the receiver baseboard and through which generated power is extracted from the photovoltaic cell element, a connector having a connector terminal connected to the connection terminal, and a receiver resin sealing portion configured to cover the connection terminal, the connector terminal, and the receiver baseboard, the method comprising the steps of:
fastening the receiver baseboard to the heat sink;
placing the photovoltaic cell element and the receiver baseboard in the opening, covering the opening with the heat sink, and fastening the heat sink to the module plate around the opening;
connecting the connector terminal to the connection terminal and fastening the connector to the heat sink; and
forming the receiver resin sealing portion configured to cover the connection terminal, the connector terminal, and the receiver baseboard.
